# EUROPEAN PATENT APPLICATION

(11) **EP 0 783 111 A2**
(43) Date of publication of application: **09.07.1997**
(21) Application number: 96402729.6
(22) Date of filing: 13.12.1996
(51) Int. Cl.: G01R 22/00

(54) **Electrical heating control device**

(30) Priority: 05.01.1996 GB 9600160
(71) Applicant: Schlumberger Industries Limited, Suffolk IP 11 8ER (GB); Eastern Electricity plc, Ipswich, Suffolk IP9, 2AQ (GB)
(72) Inventor: Brown, David, Renfrewshire, PA 16 OXR, Schotland (GB); Robinson, Andrew Michael, Felixstowe, Suffolk IP11 9SP (GB); Vaughan, John, Felixstowe IP11 7EQ (GB)
(74) Representative: Hawkes, David John

(57) **Abstract**

An electrical control device 10 for controlling an electric heating system, the device comprising an input 12, 14 for receiving a metered electricity supply; an output 16, 18 for connection to the heating system; switch means 22 connected between the input and the output; communication means 26 for receiving transmitted tariff messages containing data relating to the cost of the electricity being supplied; a control circuit 24, 32 responsive to the communication means to close the switch means during one or more periods when the cost of the electricity is relatively low; manually operable means 21 for closing the switch means; sensing means 34, 36 for sensing the amount of electricity supplied to the heating system, the control circuit being responsive to the sensing means to accumulate the amounts of electricity supplied during one or more of said periods; and display means 38 for producing a display representative of said accumulated amounts.

## Description

This invention relates to electrical control devices for controlling electric heating systems, and is more particularly but not exclusively concerned with electrical control devices for controlling domestic electric hot water or space heating systems.

It is common practice to supply electricity to domestic consumers on a multi-tariff basis, with relatively cheap electricity being supplied at certain off-peak periods, eg during the night. However, multi-tariff supply typically requires a multi-tariff meter, which can be expensive: it is also typically time-based, ie controlled by an electrical or electronic timer, which is relatively inflexible and can easily lose its synchronisation with the intended off-peak switching times.

Additionally, in the United Kingdom at the present time, the price paid by the electricity distributors to the electricity generators varies more widely and more frequently than used to be the case, typically changing every half hour. Consequently, a conventional time-based multi-tariff system having one or two fixed off-peak periods is no longer sufficiently flexible to take full advantage of the periods when electricity costs are actually the lowest.

It is an object of the present invention in its broadest aspect to provide an electrical switching device which can be used in conjunction with a certified single rate meter to control an electric heating system in a manner which permits the equivalent of a multi-rate tariff to be applied. It is a further object of the invention, in its more detailed implementations, to provide an electrical switching device which can respond to frequently changing electricity costs in a flexible manner.

According to the present invention, there is provided an electrical control device for controlling an electric heating system, the device comprising an input for receiving a metered electricity supply; an output for connection to the heating system; switch means connected between the input and the output; communication means for receiving transmitted tariff messages containing data relating to the cost of the electricity being supplied; a control circuit responsive to the communication means to close the switch means during one or more periods when the cost of the electricity is relatively low; manually operable means for closing the switch means; sensing means for sensing the amount of electricity supplied to the heating system, the control circuit being responsive to the sensing means to accumulate the amounts of electricity supplied during one or more of said periods; and display means for producing a display representative of said accumulated amounts.

In use, since the control device is intended to be used in conjunction with a metered electricity supply, the user's electricity bills remain primarily based on the readings of the already existing (and certified) meter, hereinafter called the primary meter, which is connected in the supply circuit up-circuit of the device: in particular, the primary meter does not need to be changed or modified. However, the control device can control the heating system so that it primarily uses low cost electricity, the metering means meters and displays a representation of the amount of this low cost electricity usage, and the electricity supplier can give the user a discount based on the displayed representation. The user nevertheless retains the freedom to switch on the heating system, using the manually operable means, at any time, but usage outside low cost periods does not contribute to the displayed representation of low cost usage, and so does not contribute to the discount.

In one embodiment, the communication means may comprise a radio receiver means for receiving broadcast tariff messages. Such a system is particularly suited for the UK market, for example, in which tariff changes are signalled by a radio signal. Other embodiments are nevertheless possible, for example, where tariff change messages are sent by power line communication or ripple control signals.

The display means may be arranged to display direct representations of said accumulated amounts, eg in kilowatt hours, in which case it would typically be read by the electricity supplier at the same time that the primary meter is read. Alternatively and preferably, the display means may be arranged to display representations of said accumulated amounts in encrypted form, in which case the user could send details of the encrypted representations to the electricity supplier, for example once a year, in order to obtain the aforementioned discount.

Where, as will often be the case, the load represented by the heating system is substantially fixed, the sensing means may simply comprise means for sensing that current is flowing through the device. Alternatively, the sensing means may comprise a current sensor, such as a shunt, for producing a signal representative of the magnitude of the current flowing through the device, and may additionally comprise a voltage sensor, such as a potential divider, for producing a signal representative of the electricity supply voltage, the control circuit including analogue-to-digital converter means connected to receive and convert the or each sensor signal into a corresponding digital signal, and being arranged to derive said accumulated amounts from the or each digital signal.

The control circuit preferably comprises a microprocessor, which may conveniently also serve as part of said analogue-to-digital converter means.

Where the heating system is thermostatically controlled at a desired temperature, the control device is advantageously programmable to control the heating system so that it reaches the desired temperature at at least one user-selected time. In this case, the control circuit is preferably arranged to sense the initial operation of the thermostat on successive days, to calculate therefrom the average time taken by the heating system to reach the desired temperature, and to select the periods for which it closes the switch means in dependence upon the calculated average time.

The invention will now be described, by way of example only, with reference to the accompanying drawing, which is a schematic diagram of an electrical control device in accordance with the present invention.

The electrical control device shown in the drawing is indicated generally at 10, and is intended to control a domestic electric hot water system. The device 10 comprises live and neutral input terminals 12, 14 respectively, which are connected in use to receive a metered mains electricity supply, and live output terminals 16,18 respectively which are connected in use to the hot water system, the terminals 12, 14, 16 and 18 being disposed inside a plastics housing 20. The live input terminal 12 is connected internally of the housing 20 to the live output terminal 16 via one pole of a manually-operable two-pole switch 21 and a 16 amp switching relay 22, while the neutral input terminal is connected within the housing 20 to the neutral output terminal 18 via the other pole of the switch 21.

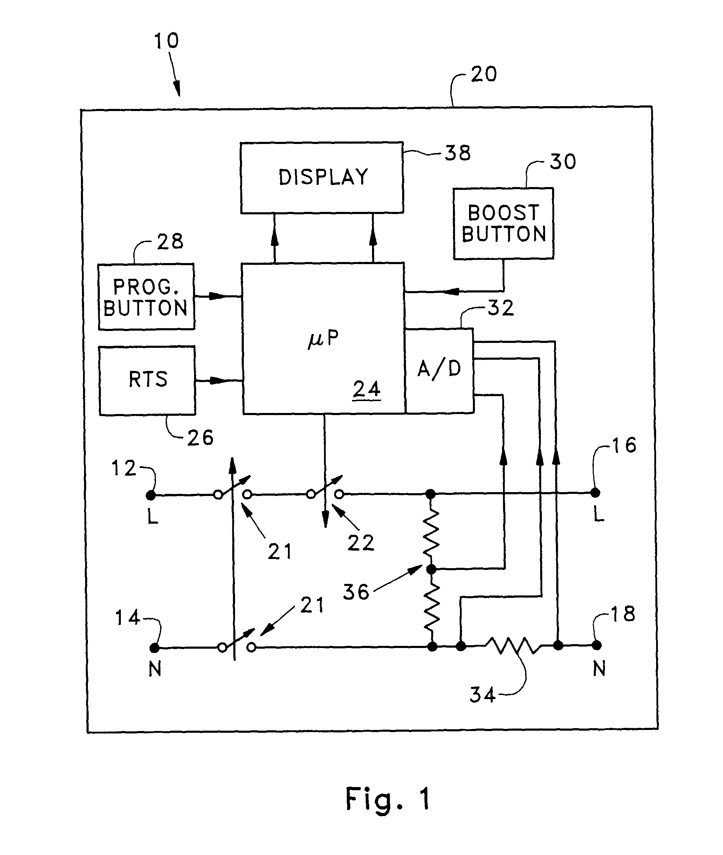

The relay 22 is connected to be operated by a microprocessor 24, which receives inputs from a radio teleswitch receiver 26 of the kind described in our United Kingdom Patent No 2 070 897. The microprocessor 24 also receives inputs from a set of manually-operable control/programming buttons 28, from a manually-operable "BOOST" button 30 and from an analogue-to-digital converter 32. The analogue-to-digital converter 32 is connected in turn to receive a first analogue input signal representative of the magnitude of the current flowing between the neutral terminals 14, 18, this signal being produced for example by a shunt 34 connected in series between the neutral terminals, and a second analogue input signal representative of the magnitude of the voltage between the output terminals 16, 18, produced for example by a voltage divider 36. Although the analogue-to-digital converter 32 is shown for the sake of clarity as a self-contained item, it can be at least partly constituted by the microprocessor 24, for example as described in relation to the microprocessor 44 of Figure 1 of the aforementioned patent.

The device 10 is also provided with a liquid crystal display (LCD) 38, which is energised by the microprocessor 24 and can be cycled between a variety of display modes in response to operation of the buttons 28, as will become apparent hereinafter.

Finally, the power supply (not shown) for the electronic circuitry of the device 10 is coupled to the live and neutral input terminals 12, 14, ie up-circuit of the switch 21 and the relay 22.

Before the device 10 is installed, the microprocessor 24 is typically initially programmed to assume that the electric heating element in the hot water system will take, say, three hours to produce a full tank of hot water, and that the user will require such a full tank to be available at, say, 7.00 am and 7.00 pm. Once the device 10 is installed, however, the user can enter the device into its programming mode via one of the buttons 28, whereupon these initially set times are displayed by the LCD 38, and can be changed by the user if desired, using others of the buttons 28.

In operation, the radio teleswitch receiver 26 receives and decodes digital signals broadcast by the BBC by modulating them on its Radio 4 transmission at 198 kHz, these signals being broadcast on behalf of the electricity generating, transmission and distribution companies. The digital signals include cost reflective messages (CRMs) indicative of the respective pool price of electricity for each successive half hour period. The microprocessor 24 is programmed to store and analyse the CRMs, which typically exhibit a generally similar pattern of cost variation each day, so as to identify, say, the six CRMs representing the lowest cost half hour periods in, say, the four hours before each of the two target times for a full tank of hot water. The microprocessor 24 then closes the relay 22 during each of the six identified periods, so heating the water using the lowest cost electricity. The current state of the relay 22, ie whether it is open or closed, is displayed by the LCD 38, although a separate light-emitting diode (LED) or other light-emitting device can be provided for this purpose if desired.

However, most if not all electric hot water systems are thermostatically controlled, so that when the hot water reaches the temperature set by the thermostat, the thermostat switches off. The device 10 senses this via the shunt 34 and the analogue-to-digital converter 32, and the microprocessor 24 calculates the average heating time taken, over several sucessive days or heating cycles, before the thermostat initially switches off. Assuming that this calculation determines that the average heating time is only, say, one and one half hours, the microprocessor 24 modifies the switching pattern of the relay 22 so that it closes during three of the lowest cost half hour periods in, say, the three hours before each of the two target times for a full tank of hot water.

The adaptive process by which the microprocessor 24 identifies the CRMs representing the lowest cost half hour periods and measures the average heating time to achieve a full tank of hot water is periodically repeated, eg on a weekly basis, so as to continually update the actual heating control profile followed by the device 10.

For some (but not necessarily all) of the low cost half hour periods, for example some or all of the night time periods, the electricity distributor may be willing to offer a discount to the user. These periods, hereinafter called discount periods, are identified by digital signals transmitted with or as part of the CRMs, which signals cause the microprocessor 24 to measure the amount of electricity being used during the discount periods. The microprocessor 24 does this by multiplying together the digital current- and voltage-representative signals produced by the analogue-to-digital converter 32, and accumulating the results in a non-volatile memory, eg an EEPROM (not shown). In order to obtain the discount, the user periodically operates a respective one of the buttons 28, which is arranged to cause the microprocessor 24 to encrypt the total amount of electricity stored in the memory and display the encrypted result. The user then conveys the encrypted result to the electricity distributor, eg by post, and the distributor calculates the appropriate discount.

In the event that the user wishes to switch the hot water system on at times outside the periods which lead up to the programmed target times, the "BOOST" button 30 is used. Typically, the microprocessor 24 is programmed to close the relay for 30 minutes in response to a single operation of the button 30, and for one hour and two hours respectively in response to two and three operations of the button 30 in reasonably rapid succession: a fourth operation, again following rapidly after the third, cancels the operation of the "BOOST" facility. However, the microprocessor 24 does not measure the amount of electricity used during these "BOOST" periods, so that no discount applies to them, unless they happen to overlap periods identified as discount periods, in which case measurement takes place during the overlap period only.

Similarly, if the user wishes to switch the hot water system off at a time when the relay 22 is closed by the microprocessor 24, the switch 21 is used. However, since the power supply for the electronic circuitry of the device 10 is connected up-circuit of the switch 21 and the relay 22, the electronic circuitry continues to operate.

Many modifications can be made to the described embodiment of the device 10.

For example, the shunt 34 can be replaced by another suitable current sensor, such as a current transformer or a Hall effect device, in which case it can be arranged to sense the live current rather than the neutral current. Also, the voltage between the output terminals 16, 18 can be assumed to be substantially constant, in which case the voltage divider 36 can simply be omitted. In the limit, the electrical load represented by the hot water system can also be assumed to be substantially constant, in which case the current sensor, whether it be shunt, current transformer or Hall effect device, merely needs to sense whether or not current is flowing at the output terminals of 16, 18 of the device 10, and the analogue to digital converter 32 can be replaced by a simple comparator or other threshold device.

In another modification, the radio receiver means may be replaced by alternative communication means for receiving tariff change information, for example, a ripple control or power line communication receiver.

In another modification, the microprocessor 24 is arranged to display the amount of low cost, discountable, electricity accumulated in the EEPROM or other non-volatile memory directly, eg in kilowatt hours, either along with an encrypted number which is derived from it and which can be used to verify it, or alone; in the latter case, the electricity distributor would read the displayed amount at the same time that the primary meter is read, typically at least once per year.

In yet another modification, the switch 21 can be omitted, and operation of the "BOOST" button 30 (or of a separate "OFF" button (not shown)) when the relay 22 is already closed can be arranged to open the relay via the microprocessor 24.

Finally, broadcast digital signals can be arranged to define more than one level of discount, and the device 10 can be programmed to identify these levels and accumulate separately the amounts of electricity used at each level.

## Claims

1. An electrical control device (10) for controlling an electric heating system, the device comprising an input (12, 14) for receiving a metered electricity supply; an output (16, 18) for connection to the heating system; switch means (22) connected between the input and the output; communication means (26) for receiving transmitted tariff messages containing data relating to the cost of the electricity being supplied; a control circuit (24, 32) responsive to the communication means to close the switch means during one or more periods when the cost of the electricity is relatively low; manually operable means (21) for closing the switch means; sensing means (34, 36) for sensing the amount of electricity supplied to the heating system, the control circuit being responsive to the sensing means to accumulate the amounts of electricity supplied during one or more of said periods; and display means (38) for producing a display representative of said accumulated amounts.

2. A device as claimed in claim 1, wherein the display means (38) is arranged to display direct representations of said accumulated amounts.

3. A device as claimed in claim 1 or claim 2, wherein the display means (38) is arranged to display representations of said accumulated amounts in encrypted form.

4. A device as claimed in any preceding claim, wherein the sensing means (34, 36) comprises means for sensing that current is flowing through the device.

5. A device as claimed in any one of claims 1 to 3, wherein the sensing means (34, 36) comprises a current sensor (34) for producing a signal representative of the magnitude of the current flowing through the device.

6. A device as claimed in claim 5, wherein the sensing means (34, 36) additionally comprises a voltage sensor (34) for producing a signal representative of the electricity supply voltage.

7. A device as claimed in claim 5 or claim 6, wherein the control circuit (24, 32) includes analogue-to-digital converter means (32) connected to receive and convert the or each sensor signal into a corresponding digital signal, and is arranged to derive said accumulated amounts from the or each digital signal.

8. A device as claimed in any preceding claim, wherein the control circuit (24, 32) comprises a microprocessor (24).

9. A device as claimed in any preceding claim, for use where said heating system includes a thermostat for controlling it at a desired temperature, the device (10) being programmable to control the heating system so that it reaches the desired temperature at at least one user-selected time.

10. A device as claimed in claim 9, wherein the control circuit (24, 32) is arranged to sense the initial operation of the thermostat on successive heating cycles, to calculate therefrom the average time taken by the heating system to reach the desired temperature, and to select the periods for which it closes the switch means (22) in dependence upon the calculated average time.

11. A device as claimed in any proceeding claim, wherein the communication means (26) comprises a radio receiver means for receiving broadcast tariff messages.
